# EUROPÄISCHE PATENTANMELDUNG

(11) **EP 3 367 433 A1**
(43) Veröffentlichungstag der Anmeldung: **29.08.2018**
(21) Anmeldenummer: 18156503.7
(22) Anmeldetag: 13.02.2018
(51) Int. Cl.: H01L 23/373, H01L 21/48, H01L 23/367, H01L 23/42

(54) **KONTAKTANORDNUNG**

(30) Priorität: 28.02.2017 DE 102017203217
(71) Anmelder: Robert Bosch GmbH, 70442 Stuttgart (DE)
(72) Erfinder: Orso, Steffen, 72764 Reutlingen (DE); Breitenbach, Marlies, 72764 Reutlingen (DE); Keil, Manuela, 72622 Nuertingen (DE); Mueller, Bjoern Jakob, 72074 Tuebingen (DE)

(57) **Zusammenfassung**

Ausgegangen wird von einer Kontaktanordnung, umfassend einen Schaltungsträger mit einer Metallisierung auf einer Oberseite und einer Unterseite, und einen Kühlkörper. Eine Kühlkörperseite ist dabei mit der Unterseite des Schaltungsträgers über eine Verbindungsschicht aus einem Verbindungsmaterial verbunden. Zwischen der Verbindungsschicht und der Kühlkörperseite einerseits und der Verbindungsschicht und der Unterseite des Schaltungsträgers andererseits ist jeweils eine Verbindungsfläche ausgebildet. Die Verbindungsschicht weist zumindest zu der Unterseite des Schaltungsträgers abgewandt oder zu der Kühlkörperseite abgewandt eine Vertiefungsstruktur auf, die jeweils aufgrund von für das Verbindungsmaterial nicht benetzbare Bereiche der Unterseite des Schaltungsträgers und/oder der Kühlkörperseite ausgebildet ist. Durch die Vertiefungsstruktur ist auch jeweils zumindest ein zusammenhängendes Luftkanalsystem ausgebildet, welches eine erste Verbindungsfläche umschließt und diese gegenüber zumindest einer weiteren Verbindungsfläche abgrenzt.

## Beschreibung

Die Erfindung betrifft eine Kontaktanordnung, umfassend einen Schaltungsträger und einen Kühlkörper, gemäß dem Oberbegriff des unabhängigen Anspruches.

### Stand der Technik

Schaltungsträger, wie z.B. Keramik basierte DBC-Substrate (direct bonded copper) oder AMB-Substrate (active metal brazing), werden zur besseren Wärmeableitung möglichst vollflächig mit einem Kühlkörper stoffschlüssig verbunden, beispielsweise mittels Weichlot. Bei dem DBC Herstellungsprozess werden Keramik Substrate, z.B. Al2O3 (typische Dicken 0,25-1,0 mm), beidseitig mit Kupferlagen (Dicken zwischen 0,127 - 0,4 mm) durch einen Ofenprozess verbunden. Um später elektrische Schaltungen zu realisieren, werden Kupferstrukturen freigeätzt.

Unter Temperaturwechselbelastung altern die Komponenten des Schaltungsträgers, aber auch die Anbindung des Schaltungsträgers auf dem Kühlkörper. Im ungünstigen Fall kommt es zur Ausbildung eines Risses. Dadurch beginnt die Anbindung an den Kühlkörper, z.B. das Lot zwischen dem DBC-Substrat und dem Kühlerkörper, vom Rand nach innen zu degradieren. Durch die somit verminderte Anbindungsfläche verringert sich die mögliche Entwärmung des Schaltungsträgers. Diese Verbindungsfläche bestimmt damit die Lebensdauer des Schaltungsträgers.

Aus der Patentschrift DE 40 04844 C1 ist ein beidseitig metallisierter Schaltungsträger mit einem Keramiksubstrat bekannt, bei welcher nur auf der einen zur Bestückung mit elektrischen Bauelementen angedachten Metallisierungsseite Ätzstrukturen eingebracht sind zur Verhinderung einer Rißbildung im Keramiksubstrat.

### Offenbarung der Erfindung

### Vorteile der Erfindung

Der Erfindung liegt die Aufgabe zu Grunde, die Rißausbreitung in einer Verbindungsschicht zwischen einem Schaltungsträger und einem verbundenen Kühlkörper zu unterbinden.

Diese Aufgabe wird durch eine Kontaktanordnung mit den kennzeichnenden Merkmalen der unabhängigen Ansprüche gelöst.

Ausgegangen wird von einer Kontaktanordnung, umfassend einen Schaltungsträger mit einer Metallisierung auf einer Oberseite und einer Unterseite, und einen Kühlkörper. Eine Kühlkörperseite ist dabei mit der Unterseite des Schaltungsträgers über eine Verbindungsschicht aus einem Verbindungsmaterial verbunden. In vielen Anwendungsfällen ist der Kühlkörper als eine Kühlkörperplatte ausgebildet, insbesondere aus Aluminium oder Kupfer, welche dann mit einer flachen Kühlkörperseite einer flachen Unterseite des Schaltungsträgers gegenüber steht. Zwischen der Verbindungsschicht und der Kühlkörperseite einerseits und der Verbindungsschicht und der Unterseite des Schaltungsträgers andererseits ist jeweils zumindest eine Verbindungsfläche ausgebildet. Die Verbindungsfläche kennzeichnet einen Stoffschluss an den Grenzflächen der Verbindungspartner. Die Verbindungsschicht weist zumindest zu der Unterseite des Schaltungsträgers abgewandt oder zu der Kühlkörperseite abgewandt eine Vertiefungsstruktur auf, die jeweils aufgrund von für das Verbindungsmaterial nicht benetzbare Bereiche der Unterseite des Schaltungsträgers und/oder der Kühlkörperseite ausgebildet ist. Bedingt durch die nicht benetzbaren Bereiche ist ein Stoffschluss zwischen den Verbindungspartnern nicht ermöglicht. Es ist dabei festzustellen, dass das Verbindungsmaterial zu derartigen nicht benetzbaren Bereichen aufgrund von molekularphysikalischen Effekten, insbesondere aufgrund von Grenzflächenspannungen, mit einem bestimmten Abstandsmaß absteht - unter Ausbildung eines Luftspaltes. Indem nicht benetzbare Bereiche unmittelbar an benetzbare Bereiche angrenzen, zeigt sich der Effekt in der Ausbildung der Vertiefungsstruktur in der Verbindungsschicht. Durch die Vertiefungsstruktur ist auch jeweils zumindest ein zusammenhängendes Luftkanalsystem ausgebildet, welches eine erste Verbindungsfläche umschließt und diese gegenüber zumindest einer weiteren Verbindungsfläche abgrenzt. Betrachtet sind hierbei ein zusammenhängendes Luftkanalsystem und mehrere Verbindungsflächen zum einen in Bezug auf die Unterseite des Schaltungsträgers und zum anderen in Bezug auf die Kühlkörperseite. Bevorzugt ist die Kontaktanordnung mit einer vollflächigen Verbindung der Kühlkörperseite ausgeführt.

Das Luftkanalsystem wirkt vorteilhaft als eine Rißstoppstruktur innerhalb der Verbindungsschicht. Hat sich beispielsweise aufgrund von Temperaturwechselbelastungen oder aus anderen Gründen ein Riss in der Verbindungsschicht gebildet, führt dieser zu einer flächigen Degradation zwischen den Verbindungspartnern. Gelangt der Riss durch eine in Gang gesetzte Risswanderung bis in den Bereich des ausgebildeten Luftkanalsystems, kommt der Riss dort zum Erliegen. Die Spannungserhöhung an der Rissspitze wird durch eine Vergrößerung des Radius beim Eindringen in den Luftkanal stark reduziert. Es wird daraufhin eine erneute Aktivierungsenergie benötigt, um einen neuen Riss bzw. eine Degradation zu starten. Insgesamt kann auf diese Weise die Lebensdauer der Kontaktanordnung wirkungsvoll verlängert werden.

In einer bevorzugten Ausführungsform der Kontaktanordnung ist die Verbindungsschicht gebildet durch eine verfestigte Lotschicht, insbesondere aus einem Weichlot, einem Hartlot oder einem Diffusionslot als Verbindungsmaterial. Ein Lotmaterial lässt sich in einfacher Weise flächig zwischen dem Schaltungsträger und dem Kühlkörper einbringen. Indem es in eine flüssige Form gebracht wird, beispielsweise durch eine Temperaturbehandlung, kommt es zu unterschiedlichen Wechselwirkungen gegenüber benetzbaren und nicht benetzbaren Bereichen der Verbindungspartner. Durch ein Verfestigen des Lotmateriales lässt sich dann dabei die oben genannte Verbindungsstruktur in sehr einfacher Weise ausformen.

Alternative Verbindungsmaterialien können beispielsweise ein Sintermaterial, ein Laminatmaterial oder ein Wärmeleitkleber sein.

Eine vorteilhafte Ausführungsform sieht vor, dass der Schaltungsträger ein polymeres oder keramisches Trägermaterial für die Metallisierung der Ober-und Unterseite aufweist. Dabei kann es sich beispielsweise um ein DBC- (direct bonded copper), ein IMS (insulated metal substrat), ein AMB- (active metal brazing) oder ein PCB - Substrat (printed circuit board) handeln. Hierbei sind die für das Lotmaterial nicht benetzbaren Bereiche zumindest gebildet durch eine Vertiefungsstruktur in der Metallisierung der Unterseite des Schaltungsträgers, welche zumindest bis zu dem polymeren oder keramischen Trägermaterial reicht. In den bis zum Trägermaterial freigelegten Bereichen ist ein Stoffschluss unterbunden. Die Vertiefungsstruktur kann beispielsweise durch ein Freiätzen eingebracht werden. Alternativ können auch mechanisch abtragende Verfahren eingesetzt werden, wie beispielsweise durch Fräsen oder Lasern. Die eingebrachte Vertiefungsstruktur in der Metallisierung bildet insgesamt das oben genannte Luftkanalsystem mit aus.

In einer Weiterbildung der Ausführungsform weist auch die Metallisierung der Oberseite des Schaltungsträgers eine Vertiefungsstruktur auf, welche ebenso zumindest bis zu dem polymeren oder keramischen Trägermaterial reicht und komplementär gegenüberliegend zu der Vertiefungsstruktur in der Metallisierung der Unterseite angeordnet ist. Auf diese Weise lässt sich bei einer erneuten Rissbildung eine Risswanderung in Richtung des Trägermaterials, beispielsweise einer Keramik, erwirken. Unter Umständen lässt sich ein Spannungsabbau bis hin zu einem Bruch des Trägermaterials in einem Randbereich des Schaltungsträgers aus Sicherheitserwägungen eher tolerieren, als ein Totalausfall einer Schaltung aufgrund einer vollständigen Degradation der Verbindungsschicht. Eine Rissumlenkung lässt sich weiter gezielt unterstützen, indem in die freigelegten Bereiche des Trägermaterials, beispielsweise aus Keramik, zusätzliche Anrisse, beispielsweise durch Lasereinschnitte, eingebracht sind.

Eine alternative Ausführungsform sieht vor, dass die für das Lotmaterial nicht benetzbaren Bereiche zumindest gebildet sind durch einen auf der Unterseite des Schaltungsträgers und/oder auf der Kühlkörperseite aufgetragenen Lötstopplack. Günstige Verfahren hierzu sind aus der Schaltungsfertigung bekannt. In Vorteilhafter Weise lassen sich dadurch auch für Lot nicht benetzbare Bereiche auf Metallkörpern, wie beispielsweise auf einem metallischen Kühlkörper, im Rahmen einer Serienfertigung preisgünstig erzeugen. Auf Seiten des Schaltungsträgers können zusätzlich zu Bereichen mit aufgetragenem Lötstopplack auch Vertiefungsstrukturen bis zum Trägermaterial für das Lotmaterial weitere nicht benetzbare Bereiche stellen.

Bei einer vorteilhaften Ausführungsform der Kontaktanordnung ist das Luftkanalsystem gebildet aus zumindest einem ersten geschlossenen Luftkanal, welcher die erste Verbindungsfläche umschließt. Ein geschlossener Luftkanal ist beispielsweise ausgeführt in Form einer Ringstruktur, bei welcher ein Luftkanalverlauf bevorzugt in einem Kreis, einem Quadrat oder einem Rechteck geführt ist. Alternativ kann der Luftkanalverlauf einem Polygonzug, insbesondere einem Vieleck, oder einer Freilinie folgen. Vorteilhaft ist dadurch erreicht, dass jeder in der Verbindungsschicht gebildete Riss, welcher in Richtung der ersten Verbindungsfläche wandert, zu Stillstand gebracht werden kann. Die erste Verbindungsfläche bleibt unabhängig von einem Rissursprung in der Verbindungsschicht allseitig von einer Degradation geschützt. Dies gilt insbesondere auch für eine Ausführung, bei welcher das Luftkanalsystem die erste Verbindungsfläche unmittelbar angrenzend umschließt.

Eine weitere günstige Ausführungsform ergibt sich dadurch, dass das Luftkanalsystem gebildet ist aus mehreren Luftkanälen, welche sich in Kreuzungspunkten überschneiden. Hierbei umschließt zumindest ein Verbund von sich schneidenden Luftkanälen die erste Verbindungsfläche. Grundsätzlich bevorzugt ist ein sich ergebender Luftkanalverlauf innerhalb der Kreuzungspunkte dem für einen geschlossenen Luftkanal entsprechend, wobei sich auch die gleichen Vorteile ergeben. Gleiches gilt auch für eine Ausführung, bei welcher der Verbund von sich schneidenden Luftkanälen die erste Verbindungsfläche innerhalb der Kreuzungspunkte unmittelbar angrenzend umschließt.

Grundsätzlich sind Ausführungsformen denkbar, bei welchen zum Beispiel ein oder mehrere geschlossene Luftkanäle ineinander verschachtelt angeordnet sind, des Weiteren solche, bei welchen ein oder mehrere dieser geschlossenen Luftkanäle selbst wieder von einem Verbund von sich in Kreuzungspunkten schneidenden Luftkanälen umschlossen sind. Insgesamt ist dadurch eine Schutzwirkung der eingeschlossenen ersten Verbindungsfläche erhöht durch Bereitstellung von mehreren hintereinander geschalteten Rissbarrieren.

Insgesamt sieht die Ausführung der Kontaktanordnung vor, dass die erste Verbindungsfläche umgeben ist von einer Vielzahl von weiteren Verbindungsflächen, welche in einer Musteranordnung durch die sich kreuzenden Luftkanäle und/oder von einem oder von den mehreren geschlossenen Luftkanälen voneinander getrennt sind. Bevorzugt sind diese weiteren Verbindungsflächen in einem Randbereich der Unterseite des Schaltungsträgers und/oder der Kühlkörperfläche angeordnet. Die weiteren Verbindungsflächen stellen weitere Entwärmungspfade zu Verfügung und erhöhen die mechanische Belastbarkeit der Kontaktanordnung.

Eine Ausführungsform der Kontaktanordnung ist derart ausgebildet, dass zumindest ein Teil des Luftkanalsystems, welcher die erste Verbindungsfläche angrenzend umschließt, in einem Randbereich des Schaltungsträgers angeordnet ist und der Außenkontur des Schaltungsträgers mit einem parallelen Versatz überwiegend folgt. Die meisten Schaltungsträger weisen beispielsweise eine rechteckige, quadratische oder runde Außenkontur auf. Abweichungen des Luftkanalverlaufs können sich beispielsweise dadurch ergeben, dass scharfwinklige Ecken abgerundet sind oder ein Luftkanal um ein schaltungsrelevantes Element des Schaltungsträgers herumgeführt ist. Ein Vorteil ergibt sich zum einen darin, dass die sich üblicherweise am Rande der Verbindungsschicht erstmalig gebildeten Risse frühzeitig in ihrer weiteren Ausbreitung unterbrochen werden, so dass die Betriebssicherheit der Kontaktanordnung optimiert wird. Zum anderen kann die erste Verbindungsfläche zentral innerhalb der Verbindungsschicht ausgeführt sein, dadurch bedingt insbesondere auch eine großflächige Anbindung des Schaltungsträgers an den Kühlkörper sicherstellen.
Bevorzugt ist die erste Verbindungsfläche größer als alle weiteren Verbindungsflächen zusammen.

Vorteilhaft ist eine Ausführungsform, bei welcher die Vertiefungsstruktur in der Verbindungsschicht in Form einer Nut ausgebildet ist, insbesondere zumindest in einem Teilausschnitt U- oder V-förmig oder dahingehend angenähert. Die Formausprägung ergibt sich maßgeblich aus einem Zusammenspiel des Verbindungsmaterials mit dem Material und der Größenabmessungen der für das Verbindungsmaterial nicht benetzbaren Bereiche. So kann vorteilhaft die Vertiefungsstruktur lokal, abschnittsweise oder insgesamt eine Nuttiefe in einem Bereich von 0,1 mm bis 3 mm, insbesondere 0,3 mm bis 0,8 mm, aufweisen und/oder eine Nutbreite in einem Bereich von 0,3 bis 4 mm, insbesondere von 0,5 mm bis 1,5 mm, aufweisen. Die Nuttiefe orientiert sich bevorzugt am Typ des Schaltungsträgers und der dort vorliegenden Dicke einer Metallisierungsschicht.

Sehr einfach lassen sich Kontaktanordnungen ausbilden, bei welchen das gebildete Luftkanalsystem durchgehend Luftkanäle mit zumindest annähernd gleichem Querschnitt und/oder einer Verlaufsorientierung in einer gemeinsamen Ebene aufweist. Alternativ weist zumindest ein Verbund von mehreren Luftkanälen eine solche Ausprägung auf.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine Ausführung einer Kontaktanordnung in einer Schnittdarstellung,
- Fig. 2:: eine weitere Ausführung einer Kontaktanordnung in einer Schnittdarstellung,
- Fig. 3a:: eine erste Ausführung einer Vertiefungsstruktur in der Verbindungsschicht in einer geschnittenen Draufsicht,
- Fig. 3b:: eine zweite Ausführung einer Vertiefungsstruktur in der Verbindungsschicht in einer geschnittenen Draufsicht,
- Fig. 3c:: eine dritte Ausführung einer Vertiefungsstruktur in der Verbindungsschicht in einer geschnittenen Draufsicht,
- Fig. 3d:: eine vierte Ausführung einer Vertiefungsstruktur in der Verbindungsschicht in einer geschnittenen Draufsicht.

### Ausführungsformen der Erfindung

In den Figuren sind funktional gleiche Bauteile jeweils mit gleichen Bezugszeichen gekennzeichnet.

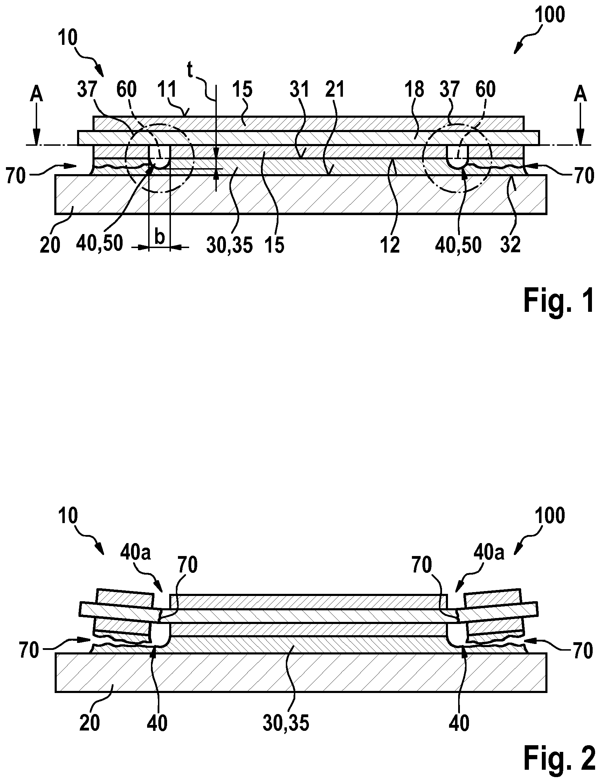

Fig. 1 zeigt eine Schnittdarstellung einer ersten Ausführungsform einer Kontaktanordnung 100, umfassend zumindest einen Schaltungsträger 10 und einen Kühlkörper 20. Der Schaltungsträger 10 weist zumindest auf seiner Unterseite 12 eine Metallisierung 15 auf, beispielsweise aus Kupfer oder Aluminium. Ferner kann auf einer Oberseite 11 des Schaltungsträgers 10 eine zusätzliche Metallisierung 15 aufgebracht sein. Die Metallisierungen 15 sind dabei auf einem polymeren oder einem keramischen Trägermaterial 18 aufgebracht. Der Schaltungsträger 10 ist beispielsweise ein DBC- (direct bonded copper), ein IMS- (insulated metal substrat), ein AMB- (active metal brazing) oder ein PCB-Substrat (printed circuit board). Auf der Oberseite 11 des Schaltungsträger 10 sind unter Ausbildung einer elektrischen Schaltung elektrische und/oder elektronischen Bauelement miteinander verbunden (nicht dargestellt). Der Kühlkörper 20 ist über eine Kühlkörperseite 21 mittels einer Verbindungsschicht 30 aus einem Verbindungsmaterial 35 mit der Unterseite 12 des Schaltungsträgers 10 verbunden. Zwischen der Verbindungsschicht 30 und der Unterseite 12 des Schaltungsträgers 10 ist dabei eine Verbindungsfläche 31 ausgebildet. Ebenso ist zwischen der Verbindungsschicht 30 und der Kühlkörperseite 21 eine weitere der zuvor genannten Verbindungsfläche 31 gegenüber liegende Verbindungsfläche 32 ausgebildet. Die Verbindungsflächen 31, 32 sind gekennzeichnet durch einen Stoffschluss zwischen dem Verbindungsmaterial 35 und den Grenzflächen der Verbindungspartner Schaltungsträger 10 und Kühlkörper 20. Der Kühlkörper 20 ist beispielsweise in Form einer Kühlkörperplatte ausgeführt und weist eine ebene Kühlkörperseite 21 auf. Auf der der Kühlkörperseite 21 gegenüber liegenden Seite können beispielsweise Kühlrippen oder Kühlstrukturen zur Verbesserung einer Kühlleistung ausgeformt sein. Die Kühlkörperseite 21 ist in vorliegendem Ausführungsbeispiel vollflächig mit dem Schaltungsträger 10 verbunden, d.h. die ausgebildete Verbindungsfläche 32 erstreckt sich bevorzugt bis zu einem Außenbereich einer auf die Kühlkörperseite 21 projizierten Fläche der Unterseite 12 des Schaltungsträgers 10.

Zur Ausbildung der Kontaktanordnung 100 ist zwischen dem Schaltungsträger 10 und dem Kühlkörper 20 ein Lotmaterial als das Verbindungsmaterial 35 eingebracht. Ein Stoffschluss wird beispielsweise dadurch erwirkt, dass das Lotmaterial 35, insbesondere durch eine Temperaturbehandlung, in eine flüssige Form gebracht wird und anschließend wieder erstarrt. Die Unterseite 12 des Schaltungsträgers weist Bereiche 36 auf, welche durch das Lotmaterial 35 in flüssiger Form benetzbar sind und andere Bereiche 37, die durch das Lotmaterial 35 nicht benetzbar sind. In den benetzbaren Bereichen 37 kann sich durch ein Erstarren des Lotmaterials 35 die Verbindungsfläche 31 bilden. In den nicht benetzbaren Bereichen 37 dagegen steht das flüssige Lotmaterial 35 leicht ab und bildet beim

Erstarren eine Vertiefungsstruktur 40 innerhalb der Verbindungsschicht 30 aus. Im vorliegenden Ausführungsbeispiel sind nicht benetzbare Bereiche 37 gebildet durch bis zum polymeren oder keramischen Trägermaterial 18 freigelegte Vertiefungen innerhalb der Metallisierung 15 der Unterseite 12. Alternativ oder zusätzlich können nicht benetzbare Bereiche 37 auch dadurch ausgeführt sein, dass ein Lötstopplack 50 (gestrichelt dargestellt) auf der Metallisierung 15 der Unterseite 12 aufgebracht ist. Bevorzugt ist die Vertiefungsstruktur 40 in Form einer Nut ausgebildet, bevorzugt im Querschnitt u-förmig oder v-förmig. Die Nut weist hierbei eine Nuttiefe t und eine Nuttiefe b auf. Weiter bevorzugt verbleibt in einem Nutgrund noch zumindest eine Restdicke der Verbindungsschicht 30 bis zur Kühlkörperseite 21. Durch die Verbindungsstruktur 40 ist insgesamt zumindest ein zusammenhängendes Luftkanalsystem 50 ausgebildet, welches eine erste Verbindungsfläche 31a zur Unterseite 12 des Schaltungsträgers 10 umschließt und diese gegenüber zumindest einer weiteren Verbindungsfläche 31b zur Unterseite 12 des Schaltungsträgers 10 hin abgrenzt.

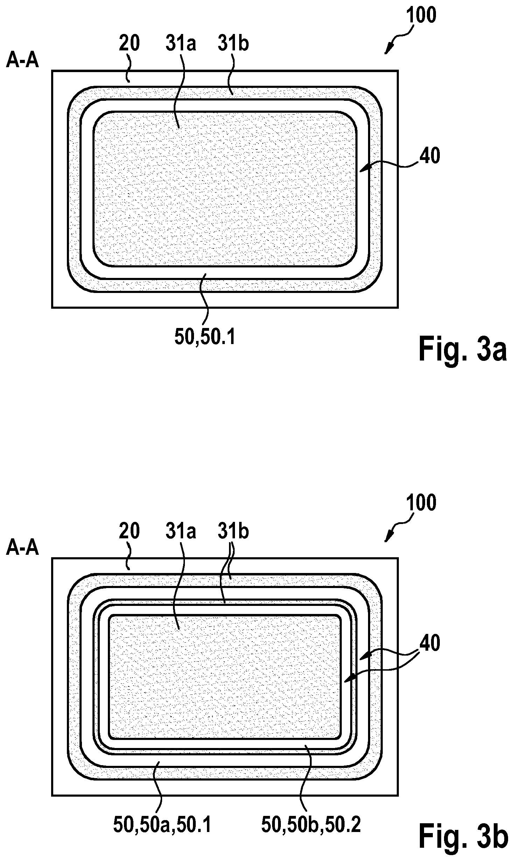

Die Vertiefungsstruktur 40 kann verschiedenartig ausgeführt sein unter Ausbildung des zumindest einen Luftkanalsystems 50. Verschiedene beispielhafte Ausführungen der Vertiefungsstruktur 40 sind durch den in Fig. 1 gezeigten Schnittverlauf in einer sich ergebenden Schnittansicht A-A in den Fig. 3a bis 3b zu sehen.

Fig. 3a zeigt beispielsweise eine erste Ausführung einer Vertiefungsstruktur 40, durch welche ein zusammenhängendes Luftkanalsystem 50 gebildet ist, umfassend einen geschlossenen Luftkanal 50.1. Der Luftkanal 50.1 ist hierbei in einer Ringstruktur ausgeführt und umschließt angrenzend eine erste Verbindungsfläche 31a. Zusätzlich ist durch den Luftkanal 50.1 die erste Verbindungsfläche 31a von einer weiteren sie einschließenden Verbindungsfläche 31b getrennt.

In der Fig. 3b sind im Vergleich zur Ausführung gemäß der Fig. 3b durch die Vertiefungsstruktur 40 zwei geschlossene Luftkanäle 50.1 und 50.2 ineinander verschachtelt ausgebildet. Durch den Luftkanal 50.1 ist ein erstes zusammenhängendes Luftkanalsystem 50a und durch den zweiten Luftkanal 50.2 ein vom ersten Luftkanalsystem 50a getrenntes zweites zusammenhängendes Luftkanalsystem 50b gebildet. Des Weiteren liegen nun neben der ersten Verbindungsfläche 31a zwei weitere Verbindungsflächen 31b beabstandet zueinander vor, welche die erste Verbindungsfläche 31a ineinander einschließen.

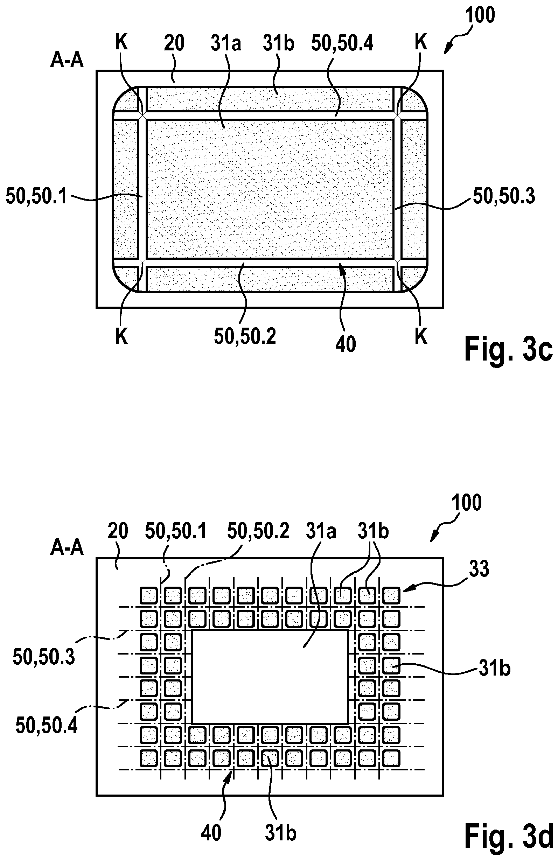

In der Fig. 3c ist die Vertiefungsstruktur 40 derart ausgeführt, dass die erste Verbindungsfläche 31a umschlossen ist von einem Verbund von mehreren sich in Kreuzungspunkten K schneidenden Luftkanälen 50.1, 50.2, 50.3, 50.4. Einzelne oder alle Luftkanäle 50.1, 50.2, 50.3, 50.4 können über einen Kreuzungspunkt K hinaus bis vollständig aus einem Randbereich der Verbindungsschicht 30 heraustretend geführt sein. Insgesamt sind außerhalb der Kreuzungspunkte K mehrere weitere Verbindungsflächen 31b über die jeweiligen Luftkanäle 50.1, 50.2, 50.3, 50.4 gegenüber der ersten Verbindungsfläche 31a getrennt.

Fig. 3d zeigt eine vierte Ausführung der Vertiefungsstruktur 40, bei welcher - ähnlich wie in Fig. 3c - eine erste Verbindungsfläche 31a von einer Vielzahl weiteren Verbindungsflächen 31b umgeben ist. Die weiteren Verbindungsflächen 31b sind hierbei aufgrund von sich überschneidenden Luftkanälen 50.1, 50.2, 50.3, 50.4 in einer Musteranordnung 33 mehrreihig angeordnet. Zur Vereinfachung ist ein Verlauf eines Luftkanals 50.1, 50.2, 50.3, 50.4 durch eine jeweilige strichpunktierte Achse visualisiert.

Grundsätzlich ergeben sich weitere Ausführungsformen durch eine Kombination von zumindest zweien gezeigten Ausführungsformen aus den Fig. 3a bis 3d. Ferner ist bevorzugt zumindest ein Teil des Luftkanalsystems 50, welcher die erste Verbindungsfläche 31a angrenzend umschließt, in einem Randbereich des Schaltungsträgers 10 angeordnet und folgt mit einem parallelen Versatz überwiegend der Außenkontur des Schaltungsträgers 10. Des Weiteren ist die erste Verbindungsfläche 31a größer als alle weiteren Verbindungsflächen 31b zusammen.

Das durch die Vertiefungsstruktur 40 gebildete zumindest eine Luftkanalsystem 50 wirkt als Rissbarriere innerhalb der Verbindungsschicht 30. Fig. 1 zeigt beispielhaft zwei Risse, welche einen Rissursprung in einem Randbereich der Verbindungsschicht 30 haben und dort bereits teilweise zu einer Degradation gegenüber der Unterseite 12 des Schaltungsträgers 10 geführt haben. Durch erstmaliges Eindringen des Risses in einen Luftkanal 50.1, 50.2, 50.3, 50.4 des zumindest einen Luftkanalsystems 50 ist eine Risswanderung vorerst unterbunden.

Die Ausführung der Fig. 2 unterscheidet sich zu der Ausführung aus Fig. 1 nur darin, dass auf der Oberseite 11 des Schaltungsträgers 10 bis zum polymeren oder keramischen Trägermaterial 18 freigelegte Vertiefungen innerhalb der Metallisierung 15 eingebracht sind. Die Vertiefungen sind als Vertiefungsstruktur 40a bevorzugt komplementär und gegenüberliegend zu der Vertiefungsstruktur 40 angeordnet. Sollte es trotzdem zu einer erneuten Rissaktivierung kommen, nachdem ein Riss bereits durch Eindringen in einen Luftkanal 50.1, 50.2, 50.3, 50.4 vorerst gestoppt wurde, so ist nun erwirkt, dass eine Rissausbreitung in Richtung der oberseitig angebrachten Vertiefung sich fortsetzen dürfte. Dadurch bleibt eine Rissausbreitung zumindest innerhalb der Verbindungsschicht 30 wirkungsvoll unterbunden.

Weitere Ausführungsformen sehen vor, dass alternativ oder zusätzlich auf Seiten des Kühlkörpers 20 die bereits gezeigte Vertiefungsstruktur 40 gleichartig ausgebildet wird, beispielsweise durch Auftragen eines Lötstopplackes auf der Kühlkörperseite 21.

## Patentansprüche

1. Kontaktanordnung (100), umfassend einen Schaltungsträger (10) mit einer Metallisierung (15) auf einer Oberseite (11) und einer Unterseite (12), und einen Kühlkörper (20), wobei eine Kühlkörperseite (21) mit der Unterseite (12) des Schaltungsträgers (10) über eine Verbindungsschicht (30) aus einem Verbindungsmaterial (35) verbunden ist und zwischen der Verbindungsschicht (30) und der Kühlkörperseite (21) bzw. der Unterseite (12) des Schaltungsträgers (10) jeweils zumindest eine Verbindungsfläche (31, 31a, 31b) ausgebildet ist,
**dadurch gekennzeichnet, dass**
die Verbindungsschicht (30) zumindest zu der Unterseite (12) des Schaltungsträgers (10) oder zu der Kühlkörperseite (21) abgewandt eine Vertiefungsstruktur (40) aufweist, die jeweils aufgrund von für das Verbindungsmaterial (35) nicht benetzbare Bereiche (37) der Unterseite (12) des Schaltungsträgers (10) und/oder der Kühlkörperseite (21) ausgebildet ist, wobei durch die Vertiefungsstruktur (40) jeweils zumindest ein zusammenhängendes Luftkanalsystem (50, 50a, 50b)ausgebildet ist, welches eine erste Verbindungsfläche (31a) umschließt und diese gegenüber zumindest einer weiteren Verbindungsfläche (31b) abgrenzt.

2. Kontaktanordnung (100) nach Anspruch,
**dadurch gekennzeichnet, dass**
die Verbindungsschicht (30) gebildet ist durch eine Lotschicht (35), insbesondere aus einem Weichlot, einem Hartlot oder einem Diffusionslot als Verbindungsmaterial oder einem Sintermaterial oder einem Laminatmaterial oder einem Wärmeleitkleber.

3. Kontaktanordnung nach einem der Ansprüche 1 oder 2,
**dadurch gekennzeichnet, dass**
der Schaltungsträger (10) ein polymeres oder keramisches Trägermaterial (18) für die Metallisierung (15) der Ober-und Unterseite (11, 12) aufweist, wobei die für das Lotmaterial (35) nicht benetzbaren Bereiche (37) zumindest gebildet sind durch eine Vertiefungsstruktur (40) in der Metallisierung (15) der Unterseite (12), welche zumindest bis zu dem polymeren oder keramischen Trägermaterial (18) reicht und das Luftkanalsystem (50, 50a, 50b) mit ausbildet.

4. Kontaktanordnung (100) nach Anspruch 3,
**dadurch gekennzeichnet, dass**
die Metallisierung (15) der Oberseite (11) des Schaltungsträgers (10) eine Vertiefungsstruktur (40a) aufweist, welche zumindest bis zu dem polymeren oder keramischen Trägermaterial (18) reicht und komplementär gegenüberliegend zu der Vertiefungsstruktur (40) in der Metallisierung (15) der Unterseite (12) angeordnet ist.

5. Kontaktanordnung (100) nach einem der vorhergehenden Ansprüche,
**dadurch gekennzeichnet, dass**
die für das Lotmaterial (35) nicht benetzbaren Bereiche (37) zumindest gebildet sind durch einen auf der Unterseite (12) des Schaltungsträgers (10) und/oder auf der Kühlkörperseite (21) aufgetragenen Lötstopplack (60).

6. Kontaktanordnung (100) nach einem der vorhergehenden Ansprüche,
**dadurch gekennzeichnet, dass**
das Luftkanalsystem (50, 50a, 50b) gebildet ist aus zumindest einem ersten geschlossenen Luftkanal (50.1, 50,2), welcher die erste Verbindungsfläche (31a) umschließt, insbesondere angrenzend umschließt.

7. Kontaktanordnung (100) nach einem der vorhergehenden Ansprüche,
**dadurch gekennzeichnet, dass**
das Luftkanalsystem (50, 50a, 50b) gebildet ist aus mehreren Luftkanälen (50.1, 50.2, 50.2, 50.3, 50.4), welche sich in Kreuzungspunkten (K) überschneiden, wobei zumindest ein Verbund von sich schneidenden Luftkanälen (50.1, 50.2, 50.2, 50.3, 50.4) die erste Verbindungsfläche (31a) umschließt, insbesondere angrenzend umschließt.

8. Kontaktanordnung (100) nach Anspruch 7,
**dadurch gekennzeichnet, dass**
die erste Verbindungsfläche (31a) umgeben ist von einer Vielzahl von weiteren Verbindungsflächen (31b), welche in einer Musteranordnung (33) durch die sich kreuzenden Luftkanäle (50.1, 50.2, 50.2, 50.3, 50.4) voneinander getrennt sind.

9. Kontaktanordnung (100) nach einem der vorhergehenden Ansprüche,
**dadurch gekennzeichnet, dass**
zumindest ein Teil des Luftkanalsystems (50, 50a, 50b), welcher die erste Verbindungsfläche (31a) angrenzend umschließt, in einem Randbereich des Schaltungsträgers (10) angeordnet ist und der Außenkontur des Schaltungsträgers (10) mit einem parallelen Versatz überwiegend folgt.

10. Kontaktanordnung (100) nach einem der vorhergehenden Ansprüche,
**dadurch gekennzeichnet, dass**
die erste Verbindungsfläche (31a) größer ist als alle weiteren Verbindungsflächen (31b) zusammen.

11. Kontaktanordnung (100) nach einem der vorhergehenden Ansprüche,
**dadurch gekennzeichnet, dass**
die Vertiefungsstruktur (40) in der Verbindungsschicht (30) in Form einer Nut ausgebildet ist, insbesondere U- oder V-förmig.

12. Kontaktanordnung (100) nach Anspruch 11,
**dadurch gekennzeichnet, dass**
die Nut eine Nuttiefe (t) in einem Bereich von 0,1 mm bis 3 mm, insbesondere 0,3 mm bis 0,8 mm, aufweist und/oder eine Nutbreite (b) in einem Bereich von 0,3 bis 4 mm, insbesondere von 0,5 mm bis 1,5 mm, aufweist.
